# EUROPEAN PATENT APPLICATION

(11) **EP 4 597 838 A1**
(43) Date of publication of application: **06.08.2025**
(21) Application number: 23891814.8
(22) Date of filing: 04.10.2023
(51) Int. Cl.: H03H 7/18, H03H 7/38

(54) **PHASE SHIFTER, ELECTRONIC DEVICE COMPRISING PHASE SHIFTER, AND METHOD FOR OPERATING SAME**

(30) Priority: 14.11.2022 KR 20220151445
(71) Applicant: Samsung Electronics Co., Ltd., Suwon-si, Gyeonggi-do 16677 (KR); The Industry & Academic Cooperation in Chungnam National University (IAC), Daejeon 34134 (KR)
(72) Inventor: LEE, Chongmin, Suwon-si Gyeonggi-do 16677 (KR); KIM, Choulyoung, Daejeon 34134 (KR); YEO, Sungku, Suwon-si Gyeonggi-do 16677 (KR); CHOI, Hanwoong, Daejeon 34134 (KR); SONG, Jaehyeok, Daejeon 34134 (KR); LIM, Jeongtaek, Daejeon 34134 (KR)
(74) Representative: Appleyard Lees IP LLP
(86) International application number: PCT/KR2023/015261
(87) International publication number: WO 2024/106745

(57) **Abstract**

A phase shifter may comprise: a center-tapped transformer comprising a primary inductor, a secondary inductor, and a center-tapped capacitor; a first switch electrically connected to the first terminal of the primary inductor; and a second switch electrically connected to the second terminal of the primary inductor. While the first switch is in an on-state and the second switch is in an off-state, an induced first RF signal having the same phase as a first RF signal input to the input terminal of the phase shifter may be output through the output terminal of the phase shifter connected to the secondary inductor. While the first switch is in an off-state and the second switch is in an on-state, an induced second RF signal having a phase difference of 180 degrees from a second RF signal input to the input terminal of the phase shifter may be output through the output terminal of the phase shifter.

## Description

### [Technical Field]

Various embodiments of the disclosure relate to a phase shifter, an electronic device including the phase shifter, and a method of operating the same.

### [Background Art]

Beamforming technology or phased-array systems may be applied to fields (e.g., communications and charging) that use electronic devices including antenna arrays. A phase shifter is an essential circuit for implementing the beamforming technology or phased-array system of electronic devices. In the case of 5G communication technology, since it operates in the mm-Wave band (20GHz or higher) and requires a wide bandwidth, a wideband operation of a phase shifter is required. For a precise operation of an electronic device including a phase shifter, the phase shifter should have a phase change with a small error, and the loss of the phase shifter should be minimized. Among multiple units forming the phase shifter, a 180-degree phase shifter has the largest phase error and loss, which needs to be improved.

### [Detailed Description of the Invention]

### [Technical Solution]

According to an embodiment, a phase shifter may include a center-tapped transformer including a primary inductor, a secondary inductor magnetically coupled to the primary inductor, and a center-tapped capacitor connect the primary inductor, a first switch electrically connected to a first terminal of the primary inductor and configured to selectively connect an input terminal of the phase shifter and the first terminal of the primary inductor, and a second switch electrically connected to a second terminal of the primary inductor and configured to selectively connect the input terminal of the phase shifter and the second terminal of the primary inductor. While the first switch is in an on state and the second switch is in an off state, an induced first RF signal having the same phase as a first RF signal input to the input terminal of the phase shifter may be output through an output terminal of the phase shifter connected to the secondary inductor. While the first switch is in an off state and the second switch is in an on state, an induced second RF signal having a phase difference of 180 degrees from a second RF signal input to the input terminal of the phase shifter may be output through the output terminal of the phase shifter.

According to an embodiment, an electronic device may include antennas, phase shifters connected to the antennas, a splitter/combiner connected to the phase shifters, an RFIC configured to provide an RF signal to the phase shifters through the splitter/combiner, and a processor. Among the phase shifters, a first phase shifter may include a center-tapped transformer including a primary inductor, a secondary inductor magnetically coupled to the primary inductor, and a center-tapped capacitor connect the primary inductor, a first switch electrically connected to a first terminal of the primary inductor and configured to selectively connect an input terminal of the first phase shifter and the first terminal of the primary inductor, and a second switch electrically connected to a second terminal of the primary inductor and configured to selectively connect the input terminal of the phase shifter and the second terminal of the primary inductor. The processor may be configured to control on/off the first switch and the second switch. While the first switch is in an on state and the second switch is in an off state, an induced first RF signal having the same phase as a first RF signal input to the input terminal of the first phase shifter may be output through an output terminal of the first phase shifter connected to the secondary inductor. While the first switch is in an off state and the second switch is in an on state, an induced second RF signal having a phase difference of 180 degrees from a second RF signal input to the input terminal of the first phase shifter may be output through the output terminal of the first phase shifter.

### [Brief Description of Drawings]

FIG. 1 is a diagram illustrating an operation of an electronic device included in a system according to an embodiment.
FIG. 2 is a diagram illustrating a phase shifter included in an electronic device according to an embodiment.
FIG. 3 is a circuit diagram illustrating a phase shifter according to an embodiment.
FIG. 4 is a flowchart illustrating a method of operating a phase shifter and an electronic device including the phase shifter according to an embodiment.
FIG. 5 is a diagram illustrating operations of a phase shifter and an electronic device including the phase shifter according to an embodiment.
FIG. 6 is a diagram illustrating operations of a phase shifter and an electronic device including the phase shifter according to an embodiment.
FIG. 7 is a circuit diagram illustrating a phase shifter according to an embodiment.
FIG. 8 is a circuit diagram illustrating a phase shifter according to an embodiment.
FIG. 9 is a diagram illustrating the circuit of a phase shifter according to an embodiment.
FIG. 10 is a graph illustrating input return loss of a phase shifter according to an embodiment.
FIG. 11 is a graph illustrating output return loss of a phase shifter according to an embodiment.
FIG. 12 is a graph illustrating insertion loss of a phase shifter according to an embodiment.
FIG. 13 is a graph illustrating phases of a signal output from a phase shifter according to an embodiment.
FIG. 14 is a graph illustrating input return loss of a phase shifter according to an embodiment.
FIG. 15 is a graph illustrating output return loss of a phase shifter according to an embodiment.
FIG. 16 is a graph illustrating insertion return loss of a phase shifter according to an embodiment.
FIG. 17 is an RMS average graph of phase errors of a phase shifter according to an embodiment.

### [Mode for Carrying out the Invention]

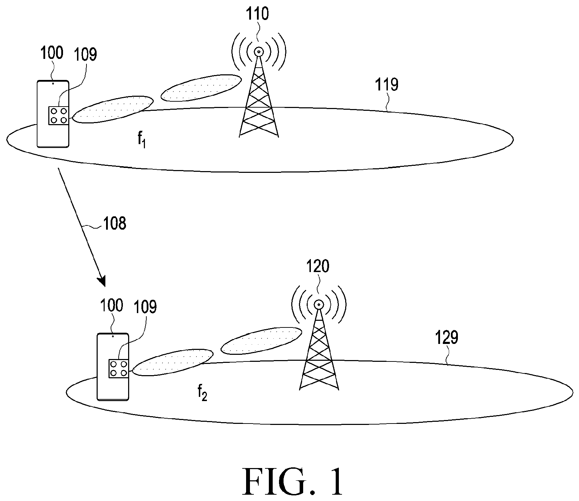

FIG. 1 is a diagram illustrating an operation of an electronic device included in a system according to an embodiment.

According to an embodiment, referring to FIG. 1, an electronic device 100 may perform communication with a base station (BS) (e.g., a first BS 110 or a second BS 220) using beamforming technology. Alternatively, although not shown, according to an embodiment, the electronic device 100 may transmit charging power to another electronic device using the beamforming technology. The electronic device 100 may receive charging power from another electronic device using the beamforming technology. The field in which the beamforming technology of the electronic device 100 is used is not limited to the communication field or the charging field.

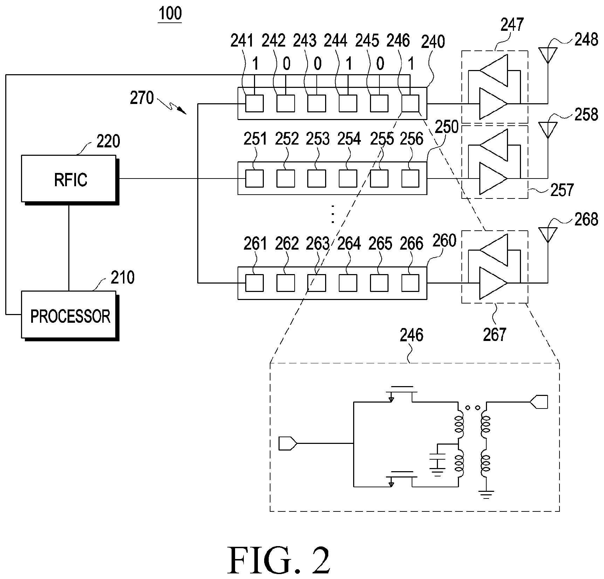

According to an embodiment, the electronic device 100 may include an antenna array 109. The electronic device 100 may include phase shifters electrically connected to antennas included in the antenna array 109, respectively. The number of phase shifters is not limited. A plurality of phase shifters may be electrically connected to a plurality of antennas included in the antenna array 109, respectively. The electronic device 100 may generate a radio frequency (RF) signal through each of the plurality of antennas included in the antenna array 109. A technology of controlling constructive interference of an RF signal at a specific point may be referred to as beamforming. The electronic device 100 may perform a beamforming operation based on control of each of the phase shifters connected to the antenna array 109. At least one of the amplitude or phase of an RF signal generated from the plurality of antennas included in the antenna array 109 may be adjusted by the electronic device 100. For convenience of description, an RF signal generated from each of the plurality of antennas included in the antenna array 109 is referred to as a sub-RF signal. The electronic device 100 may adjust at least one of the amplitude or phase of each of sub-RF signals generated from the plurality of antennas included in the antenna array 109. The sub-RF signals may interfere with each other. For example, the sub-RF signals may constructively interfere with each other at one point and destructively interfere with each other at another point. The electronic device 100 may adjust at least one of the amplitude or phase of each of the sub-RF signals generated from the plurality of antennas included in the antenna array 109, so that the sub-RF signals may constructively interfere with each other at a specific point. The electronic device 100 may control the plurality of antennas included in the antenna array 109 so that the sub-RF signals constructively interfere with each other at the specific point. Controlling the plurality of antennas included in the antenna array 109 may mean controlling the amplitude of a signal input to the plurality of antennas included in the antenna array 109 or controlling the phase (or delay) of the signal input to the plurality of antennas included in the antenna array 109. The electronic device 100 may control the phase (or delay) of the signal input to the plurality of antennas using a phase shifter. A method of controlling the phase (or delay) of a signal input to the plurality of antennas in the electronic device 100 will be described later with reference to FIG. 2.

With reference to FIG. 1, the beamforming technology of the electronic device 100 will be described in the context of the communication field, by way of example. In FIG. 1, while being located within a range 119 in which communication may be performed with the first BS 110, the electronic device 100 may perform communication with the first BS 110. The electronic device 100 may perform communication with the first BS 110 in a first frequency band having a first frequency f₁ as a center frequency by beamforming through the antenna array 109. The electronic device 100 may move 108. While being located within a range 129 in which communication may be performed with the second BS 120, the electronic device 100 may perform communication with the second BS 120. The electronic device 100 may perform communication with the second BS 120 in a second frequency band having a second frequency f₂ as a center frequency by beamforming through the antenna array 109. The first frequency f₁ between the electronic device 100 and the first BS 110 and the second frequency f₂ between the electronic device 100 and the second BS 120 may be different. The difference between the first frequency f₁ and the second frequency f₂ may be relatively large. For example, in frequency range (FR) 2 of New Radio (NR) proposed in the 3GPP, the n257 band may have a center frequency of 28GHz, the n258 band may have a center frequency of 26GHz, the n259 band may have a center frequency of 41GHz, and the n260 band may have a center frequency of 39GHz. For example, the difference between the center frequencies of the n257 band and the n258 band may be 2GHz, and the electronic device 101 may have to cover a relatively large frequency range. Accordingly, the electronic device 100 may be required to perform a wideband operation. The wideband operation of the electronic device 100 may mean that the electronic device 100 operates normally (or with capabilities at a specified level or higher) in different frequencies (e.g., the first frequency f₁ and the second frequency f₂) included in a wide range. The wideband operation of the electronic device 100 may be achieved through a phase shifter described below. The field to which the wideband operation of the electronic device 100 is applied is not limited.

FIG. 2 is a diagram illustrating a phase shifter included in an electronic device according to an embodiment.

Referring to FIG. 2, the electronic device 100 may include antennas 248, 258, and 268 that generate RF signals (e.g., sub-RF signals). The electronic device 100 may include phase shifters 240, 250, and 260 that adjust the phases (or delays) of signals input to the antennas 248, 258, and 268. The electronic device 100 may include amplifiers 247, 257, and 267 that amplify RF signals input to the antennas 248, 258, and 268. The amplifiers 247, 257, and 267 may also amplify RF signals received through the antennas 248, 258, and 268. The electronic device 100 may include a radio frequency integrated circuit (RFIC) 220 that provides RF signals. The electronic device 100 may include a splitter/combiner 270 that splits an RF signal provided from the RFIC 220 to the phase shifters 240, 250, and 260. The RF signals received through the antennas 248, 258, and 268 may be combined by the splitter/combiner 270 and provided to the RFIC 220. Each of the phases of the RF signals (e.g., sub-RF signals) may be adjusted for beamforming. Herein, an RF signal (e.g., sub-RF signal) may mean a transmission RF signal input to each of the phase shifters 240, 250, and 260 after being split by the combiner/splitter 270 and/or a received RF signal applied to each of the phase shifters 240, 250, and 260 before being combined by the combiner/splitter 270.

The RFIC 220 may support a specified high frequency band (e.g., mmWave band). Although only one RFIC 220 is illustrated in FIG. 2, the number of RFICs 220 included in the electronic device 100 is not limited. The processor 210 (e.g., modem) may provide a baseband signal. During transmission, the RFIC 220 may convert the baseband signal generated by the processor 210 into an RF signal of the specified high frequency band. During reception, the RFIC 220 may convert an RF signal provided through the splitter/combiner 270 (e.g., an RF signal into which RF signals received through the antennas 248, 258, and 268 are combined by the splitter/combiner 270) into a baseband signal, so that it may be processed by the processor 210. The electronic device 100 may include an intermediate frequency integrated circuit (IFIC) separately from or as at least a portion of the RFIC 220 according to an embodiment. In this case, the IFIC may convert a baseband signal generated by the processor 210 into an RF signal (hereinafter, "IF signal") of an intermediate frequency band, and then transmit the IF signal to the RFIC 220. The RFIC 220 may convert the IF signal into an RF signal of the specified high frequency band. During reception, RF signals may be received from the outside through the antennas 248, 258, and 268 and converted into an IF signal by the RFIC 220. The IFIC may convert the IF signal into a baseband signal so that the processor 210 may process it.

The phase shifters 240, 250, and 260 may adjust the phases of RF signals split by the splitter/combiner 270. The antennas 248, 258, and 268 may receive transmission RF signals with phases adjusted by the phase shifters 240, 250, and 260. The phase shifters 240, 250, and 260 may adjust the phases of RF signals received through the antennas 248, 258, and 268. The splitter/combiner 270 may combine the received RF signals with the phases adjusted by the phase shifters 240, 250, and 260. The phase shifters 240, 250, and 260 may be electrically connected to the antennas 248, 258, and 268, respectively.

The phase shifters 240, 250, and 260 may include multiple units. For example, referring to FIG. 2, the phase shifters 240, 250, and 260 may be controlled in 6-bit units. A bit may be a phase shifter (e.g., a sub-phase shifter 241, 242, 243, 244, 245, 246, 251, 252, 253, 254, 255, 256, 261, 262, 263, 264, 265, or 266) included in each of the phase shifters 240, 250, and 260. For example, when a phase shifter is controlled in 6-bit units, it may mean that six sub-phase shifters included in the phase shifter operate by a 6-bit control signal. However, the number of sub-phase shifters included in each of the phase shifters 240, 250, and 260 and/or the number of bits of the control signal is not limited. In FIG. 2, the first phase shifter 240 may include a first sub-phase shifter 241, a second sub-phase shifter 242, a third sub-phase shifter 243, a fourth sub-phase shifter 244, a fifth sub-phase shifter 245, and a sixth sub-phase shifter 246. Each of the first sub-phase shifter 241, the second sub-phase shifter 242, the third sub-phase shifter 243, the fourth sub-phase shifter 244, the fifth sub-phase shifter 245, and the sixth sub-phase shifter 246 may adjust the phase of an RF signal by a specified phase. For example, the first sub-phase shifter 241 may adjust a phase by a first phase (e.g., 90 degrees). The first sub-phase shifter 241 may output an RF signal with the same phase as an RF signal input to the first sub-phase shifter 241 or output an RF signal obtained by adjusting the phase of the RF signal input to the first phase shifter 241 by the first phase (e.g., 90 degrees). For example, the second sub-phase shifter 242 may adjust a phase by a second phase (e.g., 45 degrees). The second sub-phase shifter 242 may output an RF signal with the same phase as an RF signal input to the second sub-phase shifter 242 or output an RF signal obtained by adjusting the phase of the RF signal input to the second phase shifter 242 by the second phase (e.g., 45 degrees). For example, the third sub-phase shifter 243 may adjust a phase by a third phase (e.g., 11.25 degrees). The third sub-phase shifter 243 may output an RF signal with the same phase as an RF signal input to the third sub-phase shifter 243 or output an RF signal obtained by adjusting the phase of the RF signal input to the third phase shifter 243 by the third phase (e.g., 11.25 degrees). For example, the fourth sub-phase shifter 244 may adjust a phase by a fourth phase (e.g., 5.625 degrees). The fourth sub-phase shifter 244 may output an RF signal with the same phase as an RF signal input to the fourth sub-phase shifter 244 or output an RF signal obtained by adjusting the phase of the RF signal input to the fourth phase shifter 244 by the fourth phase (e.g., 5.625 degrees). For example, the fifth sub-phase shifter 245 may adjust a phase by a fifth phase (e.g., 22.5 degrees). The fifth sub-phase shifter 245 may output an RF signal with the same phase as an RF signal input to the fifth sub-phase shifter 245 or output an RF signal obtained by adjusting the phase of the RF signal input to the fifth phase shifter 245 by the fifth phase (e.g., 22.5 degrees). For example, the sixth sub-phase shifter 246 may adjust a phase by a sixth phase (e.g., 180 degrees). The sixth sub-phase shifter 246 may output an RF signal with the same phase as an RF signal input to the sixth sub-phase shifter 246 or output an RF signal obtained by adjusting the phase of the RF signal input to the sixth phase shifter 246 by the sixth phase (e.g., 180 degrees). The first phase shifter 240 may adjust a phase by a specified phase through the first sub-phase shifter 241, the second sub-phase shifter 242, the third sub-phase shifter 243, the fourth sub-phase shifter 244, the fifth sub-phase shifter 245, and the sixth sub-phase shifter 246. The processor 210 may determine phases to be adjusted by the phase shifters 240, 250, and 260. The processor 210 may provide a control signal to the phase shifters 240, 250, and 260. The phase shifters 240, 250, and 260 may adjust phases by specified phases according to the control signal provided by the processor 210. For example, in FIG. 2, the processor 210 may provide a control signal (e.g., 1, 0, 0, 1, 0, 1) to adjust a phase in the first sub-phase shifter 241, the fourth sub-phase shifter 244, and the sixth sub-phase shifter 246. For example, when the control signal is 1, the sub-phase shifter corresponding to the control signal may perform phase adjustment. When the control signal is 0, the sub-phase shifter corresponding to the control signal may output an output RF signal having the same phase as the input RF signal without performing phase adjustment. In FIG. 2, according to the control signal (e.g., 1, 0, 0, 1, 0, 1) provided by the processor 210, the first sub-phase shifter 241, the fourth sub-phase shifter 244, and the sixth sub-phase shifter 246 may output output RF signals with phases adjusted from the phase of an input RF signal, and the second sub-phase shifter 242, the third sub-phase shifter 243, and the fifth sub-phase shifter 245 may output output RF signals having the same phase as the input RF signal. As a result, the phase of an output RF signal of the first phase shifter 240 may be delayed from the phase of the input RF signal by the phases adjusted by the first sub-phase shifter 241, the fourth sub-phase shifter 244, and the sixth sub-phase shifter 246 (e.g., 275.625 degrees, which is the sum of the first phase (e.g., 90 degrees), the fourth phase (e.g., 5.625 degrees), and the sixth phase (e.g., 180 degrees)). Likewise, the processor 210 may also provide a control signal to the second phase shifter 250 (e.g., the sub-phase shifters 251, 252, 253, 254, 255, and 256 included in the second phase shifter 250) and/or the third phase shifter 260 (e.g., the sub-phase shifters 261, 262, 263, 264, 265, and 266 included in the third phase shifter 260).

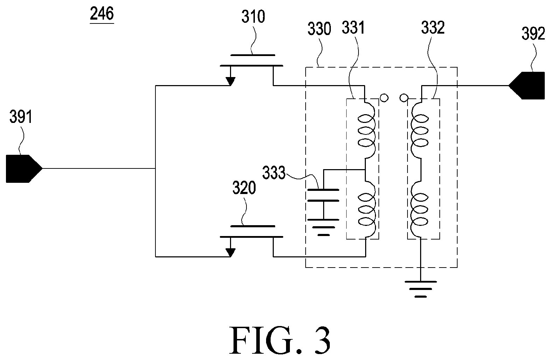

FIG. 2 is a circuit diagram illustrating the sixth sub-phase shifter 246 included in the first phase shifter 240. The circuit diagram of the sixth sub-phase shifter 246 (hereinafter, the phase shifter 246) will be described with reference to FIG. 3.

FIG. 3 is a circuit diagram illustrating a phase shifter according to an embodiment.

The phase shifter 246 of FIG. 3 may be the sixth sub-phase shifter 246 included in the first phase shifter 240 of FIG. 2. The phase shifter 246 of FIG. 3 may adjust a phase by a specified phase. The phase shifter 246 of FIG. 3 may adjust the phase by 180 degrees. The phase shifter 246 may output an RF signal having the same phase as an RF signal input to the phase shifter 246 or output an RF signal obtained by adjusting the phase of the RF signal input to the phase shifter 246 by 180 degrees.

Referring to FIG. 3, the phase shifter 246 may include a center-tapped transformer 330, a first switch 310, and a second switch 320.

The center-tapped transformer 330 may include a primary inductor 331, a secondary inductor 332 magnetically coupled to the primary inductor 331, and a center-tapped capacitor 333 connected to the primary inductor 331. The center-tapped capacitor 333 may be connected to a first point of the primary inductor 331. The primary inductor 331 may be divided into a first sub-inductor and a second sub-inductor with respect to the first point to which the center-tapped capacitor 333 is connected. Inductance of the first sub-inductor of the primary inductor 331 divided by the first point may be substantially the same as inductance of the second sub-inductor of the primary inductor 331 divided by the first point.

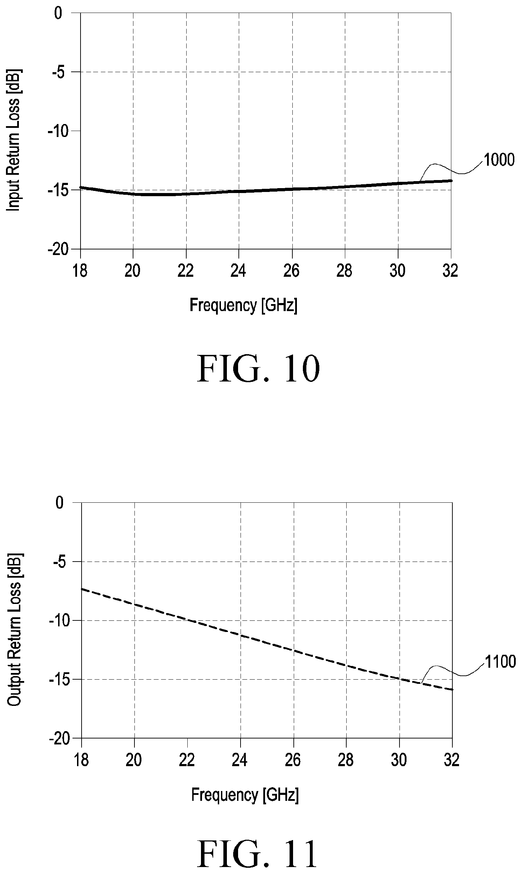

Unlike the phase shifter 246 of FIG. 3, a phase shifter using a filter structure composed of only an inductor and a capacitor may have difficulty performing a wideband operation because the filter structure performs a narrowband operation. The phase shifter 246 of FIG. 3 may be capable of a wideband operation by including the center-tapped transformer 330. Since a transfer function between two ports of a transformer (e.g., the center-tapped transformer 330) has one more pole than a transfer function between two ports in the filter structure composed of only an inductor and a capacitor, the phase shifter 246 including the center-tapped transformer 330 may perform a wideband operation. The phase shifter 246 may output an RF signal with a uniform phase by using the center-tapped transformer 330. The phase shifter 246 may perform a constant phase delay in a wideband by using the first switch 310, the second switch 320, and the center-tapped transformer 330. The wideband operation of the phase shifter 246 will be further described with reference to FIGS. 10 to 17.

Referring to FIG. 3, the first switch 310 may be electrically connected to a first terminal of the primary inductor 331. The first switch 310 may selectively connect an input terminal 391 of the phase shifter 246 and the first terminal of the primary inductor 331. For example, in an on state of the first switch 310, the input terminal 391 of the phase shifter 246 and the first terminal of the primary inductor 331 may be electrically connected to each other. In the on state of the first switch 310, an RF signal input through the input terminal 391 of the phase shifter 246 may be transmitted to the first terminal of the primary inductor 331. In an off state of the first switch 310, the input terminal 391 of the phase shifter 246 and the first terminal of the primary inductor 331 may not be electrically connected. Not being electrically connected may be expressed as being electrically blocked. In the off state of the first switch 310, the RF signal input through the input terminal 391 of the phase shifter 246 may not be transmitted to the first terminal of the primary inductor 331.

The second switch 320 may be electrically connected to a second terminal of the primary inductor 331. The second switch 320 may selectively connect the input terminal 391 of the phase shifter 246 and the second terminal of the primary inductor 331. For example, in the on state of the second switch 320, the input terminal 391 of the phase shifter 246 and the second terminal of the primary inductor 331 may be electrically connected to each other. In the on state of the second switch 320, an RF signal input through the input terminal 391 of the phase shifter 246 may be transmitted to the second terminal of the primary inductor 331. In the off state of the second switch 320, the input terminal 391 of the phase shifter 246 and the second terminal of the primary inductor 331 may not be electrically connected. In the off state of the second switch 320, the RF signal input through the input terminal 391 of the phase shifter 246 may not be transmitted to the second terminal of the primary inductor 331.

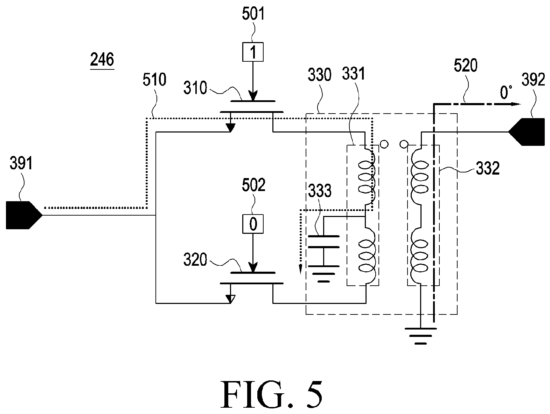

The primary inductor 331 and the secondary inductor 322 may be magnetically coupled to each other. A magnetic field may be provided around the primary inductor 331 based on an RF signal provided to the primary inductor 331. Based on the magnetic field provided around the primary inductor 331, an RF signal may be induced in the secondary inductor 332. Based on the direction or phase of the RF signal provided to the primary inductor 331, the direction of the magnetic field provided around the primary inductor 331 may be determined. Based on the direction of the magnetic field provided around the primary inductor 331, the direction or phase of the RF signal induced in the secondary inductor 332 may be determined. For example, as illustrated in FIG. 5 described below, the winding direction of the primary inductor 331 and the winding direction of the secondary inductor 322 may be the same. As illustrated in FIG. 5, since the winding direction of the primary inductor 331 and the winding direction of the secondary inductor 322 are the same, when current flows to the primary inductor 331 through the first switch 310, current may flow in the secondary inductor 332 in a direction from the output terminal 392 to a ground. As illustrated in FIG. 5, since the winding direction of the primary inductor 331 and the winding direction of the secondary inductor 322 are the same, when current flows to the primary inductor 331 through the second switch 320, current may flow in the secondary inductor 332 in a direction from the ground to the output terminal 392.

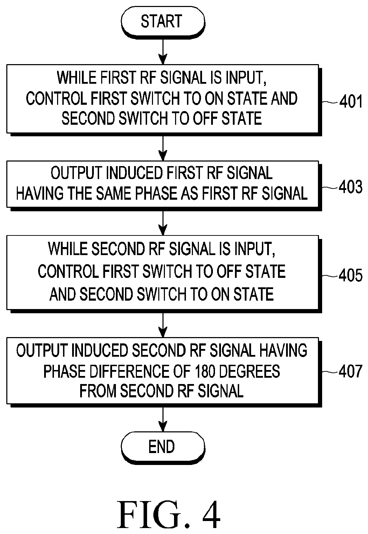

The phase shifter 246 may output an induced RF signal having the same phase as an RF signal input to the input terminal 391 of the phase shifter 246, or an induced RF signal having a phase difference of 180 degrees from the RF signal input to the input terminal 391, through the output terminal 392, depending on on/off of the first switch 310 and the second switch 320. This will be described in more detail with reference to FIG. 4.

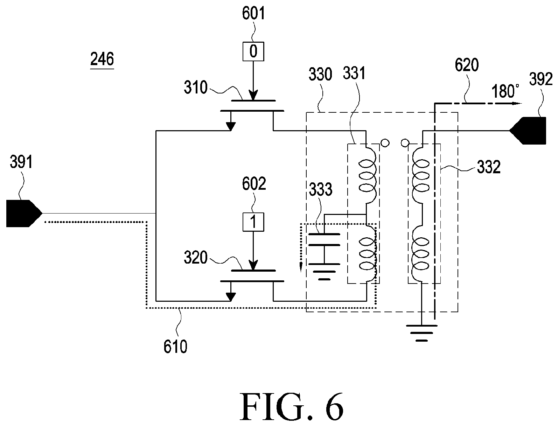

FIG. 4 is a flowchart illustrating a method of operating a phase shifter and an electronic device including the phase shifter according to an embodiment. FIG. 4 may be described with reference to FIGS. 3, 5, and 6. FIG. 5 is a diagram illustrating operations of a phase shifter and an electronic device including the phase shifter according to an embodiment. FIG. 6 is a diagram illustrating operations of a phase shifter and an electronic device including the phase shifter according to an embodiment.

Referring to FIG. 4, in operation 401, according to an embodiment, while a first RF signal is input to the input terminal 391 of the phase shifter 246, the electronic device 100 (e.g., the processor 210) may control the first switch 310 included in the phase shifter 246 to the on state and control the second switch 320 included in the phase shifter 246 to the off state. The processor 210 may provide a control signal to control the first switch 310 to the on state and the second switch 320 to the off state. For example, in FIG. 5, the first switch 310 may be controlled to the on state by a first control signal 501 (e.g., 1). In the on state of the first switch 310, the first switch 310 may be electrically short-circuited. In the on state of the first switch 310, an RF signal input to the input terminal of the phase shifter 246 may be provided to the first terminal of the primary inductor 331. The second switch 320 may be controlled to the off state by a second control signal 502 (e.g., 0). In the off state of the second switch 320, the second switch 320 may be electrically opened. In the off state of the second switch 320, the RF signal input to the input terminal of the phase shifter 246 may not be provided to the second terminal of the primary inductor 331. While the first switch 310 is in the on state and the second switch 320 is in the off state, the first RF signal input to the input terminal 391 of the phase shifter 246 may be provided to the first terminal of the primary inductor 331 through the first switch 310. While the first switch 310 is in the on state and the second switch 320 is in the off state, the first RF signal input to the input terminal 391 of the phase shifter 246 may be provided in a first direction 510 from the first terminal of the primary inductor 331 electrically connected to the first switch 310 toward the center-tapped capacitor 333. Accordingly, while the first switch 310 is in the on state and the second switch 320 is in the off state, the RF signal may be provided only to the first sub-inductor of the primary inductor 331 divided by the first point to which the center-tapped capacitor 333 is connected, and the RF signal may not be provided to the second sub-inductor of the primary inductor 331 divided by the first point, in the primary inductor 331.

In operation 403, according to an embodiment, while the first RF signal is input to the input terminal 391 of the phase shifter 246, the first switch 310 is in the on state, and the second switch 320 is in the off state, an induced first RF signal 520 having the same phase as the first RF signal input to the input terminal 391 of the phase shifter 246 may be output through the output terminal 392 of the phase shifter 246 connected to the secondary inductor 332.

In operation 403, according to an embodiment, while a second RF signal is input to the input terminal 391 of the phase shifter 246, the electronic device 100 (e.g., the processor 210) may control the first switch 310 included in the phase shifter 246 to the off state, and control the second switch 320 included in the phase shifter 246 to the on state. The processor 210 may provide a control signal to control the first switch 310 to the off state and the second switch 320 to the on state. For example, in FIG. 6, the first switch 310 may be controlled to the off state by a third control signal 601 (e.g., 0). The first switch 310 may be electrically opened. In the off state of the first switch 310, the RF signal input to the input terminal of the phase shifter 246 may not be provided to the first terminal of the primary inductor 331. The second switch 320 may be controlled to the on state by a fourth control signal 602 (e.g., 1). The second switch 320 may be electrically short-circuited. In the on state of the second switch 320, the RF signal input to the input terminal of the phase shifter 246 may be provided to the second terminal of the primary inductor 331. While the first switch 310 is in the off state and the second switch 320 is in the on state, the second RF signal input to the input terminal 391 of the phase shifter 246 may be provided to the second terminal of the primary inductor 331 through the second switch 320. While the first switch 310 is in the off state and the second switch 320 is in the on state, the second RF signal input to the input terminal 391 of the phase shifter 246 may be provided in a second direction 610 from the second terminal of the primary inductor 331 electrically connected to the second switch 320 toward the center-tapped capacitor 333. Accordingly, while the first switch 310 is in the off state and the second switch 320 is in the on state, the RF signal may be provided only to the second sub-inductor of the primary inductor 331 divided by the first point to which the center-tapped capacitor 333 is connected, and the RF signal may not be provided to the first sub-inductor of the primary inductor 331 divided by the first point, in the primary inductor 331.

In operation 407, according to an embodiment, while the second RF signal is input to the input terminal 391 of the phase shifter 246, the first switch 310 is in the off state, and the second switch 320 is in the on state, an induced second RF signal 620 having a phase difference of 180 degrees from the second RF signal input to the input terminal 391 of the phase shifter 246 may be output through the output terminal 392 of the phase shifter 246 connected to the secondary inductor 332. When the first RF signal input in operation 401 and the second RF signal input in operation 405 have the same phase, the phase of the induced second RF signal output in operation 407 may be a phase delayed by 180 degrees from the phase of the induced first RF signal output in operation 403.

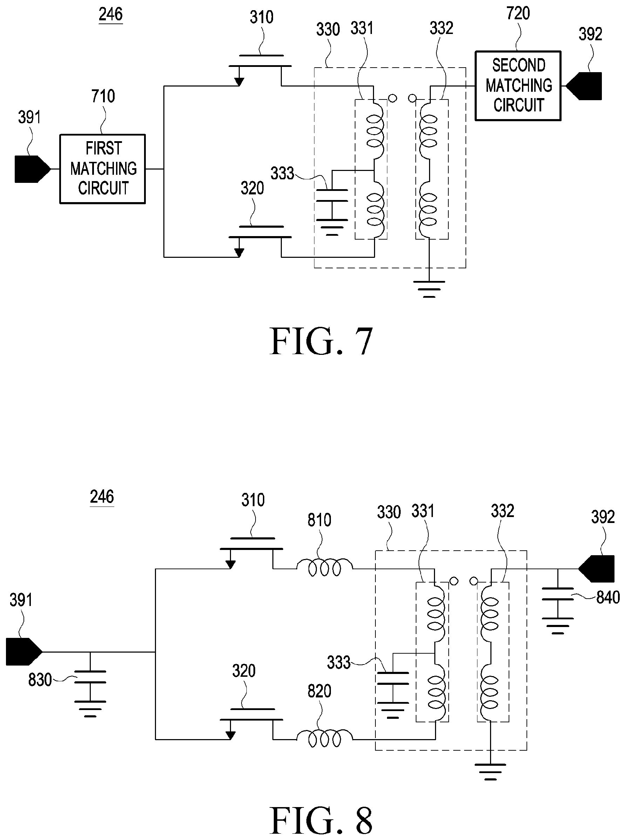

FIG. 7 is a circuit diagram illustrating a phase shifter according to an embodiment. FIG. 8 is a circuit diagram illustrating a phase shifter according to an embodiment.

With reference to FIG. 7, a phase shifter (e.g., the phase shifter 246) including a matching circuit (e.g., a first matching circuit 710 and/or a second matching circuit 720) may be described. With reference to FIG. 8, an example of the matching circuit (e.g., the first matching circuit 710 and/or the second matching circuit 720) may be described. With reference to FIG. 8, a phase shifter (e.g., the phase shifter 246) including an additional inductor (e.g., a third inductor 810 and a fourth inductor 820) may be described.

Referring to FIG. 7, the phase shifter 246 may include the center-tapped transformer 330, the first switch 310, the second switch 320, and a matching circuit (e.g., the first matching circuit 710 and/or the second matching circuit 720). Although FIG. 7 is shown as including both the first matching circuit 710 and the second matching circuit 720, the phase shifter 246 may include only one of the first matching circuit 710 and the second matching circuit 720. The phase shifter 246 may include the first matching circuit 710 electrically connected to the first switch 310 and the second switch 320. The phase shifter 246 may include the second matching circuit 720 electrically connected to a first terminal of the secondary inductor 332. A second terminal of the secondary inductor 332 may be connected to the ground.

The matching circuit (e.g., the first matching circuit 710 and/or the second matching circuit 720) may include an inductor and/or a capacitor. The matching circuit (e.g., the first matching circuit 710 and/or the second matching circuit 720) may be a circuit in which the inductor and/or the capacitor may be connected in series/parallel to be combined. The first matching circuit 710 may be a circuit for impedance matching (e.g., 50[ohm]) toward the input terminal 391 of the phase shifter 246. The second matching circuit 720 may be a circuit for impedance matching (e.g., 50[ohm]) toward the output terminal 392 of the phase shifter 246. For example, referring to FIG. 8, the first matching circuit 710 may include a first capacitor 830. Based on capacitance of the first capacitor 830, impedance matching may be performed toward the input terminal 391 of the phase shifter 246. The second matching circuit 720 may include a second capacitor 840. Based on capacitance of the second capacitor 840, impedance matching may be performed toward the output terminal 392 of the phase shifter 246.

Referring to FIG. 8, the phase shifter 246 may include an additional inductor (e.g., a third inductor 810 and a fourth inductor 820). For example, in FIG. 8, the phase shifter 246 may include the third inductor 810 electrically connected between the first switch 310 and the first terminal of the primary inductor 331, and the fourth inductor 820 electrically connected between the second switch 320 and the second terminal of the primary inductor 331. Inductance of the third inductor 810 and Inductance of the fourth inductor 820 may be substantially the same. The phase shifter 246 may form a symmetrical structure by including the third inductor 810 and the fourth inductor 820 having substantially the same inductance. The third inductor 810 and the fourth inductor 820 may facilitate impedance matching of the phase shifter 246. Although not shown, the phase shifter 246 may also include a capacitor connected in parallel to the primary inductor 331 of the center-tapped transformer 330.

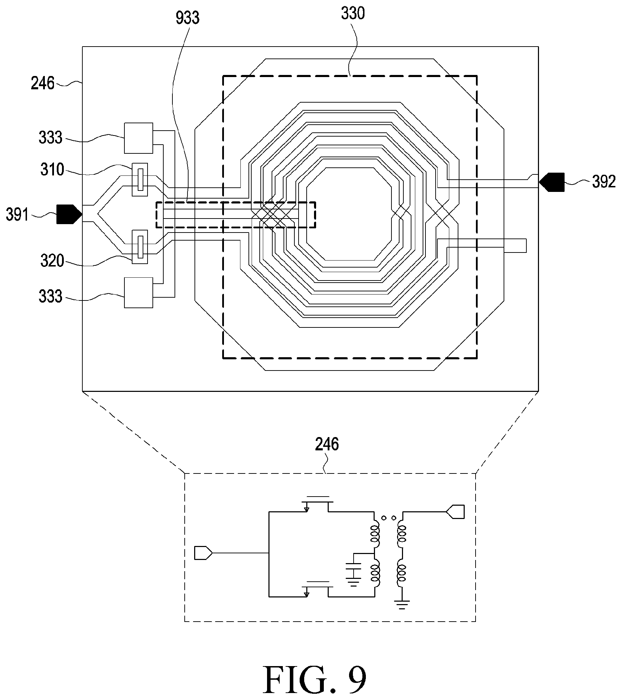

FIG. 9 is a diagram illustrating the circuit of a phase shifter according to an embodiment.

FIG. 9 is a diagram illustrating a circuit corresponding to the circuit diagram of the phase shifter 246 of FIG. 3.

Referring to FIG. 9, the phase shifter 246 may include the center-tapped transformer 330, the first switch 310, and the second switch 320, as described with reference to FIG. 3. The primary inductor (e.g., 331 in FIG. 3) and the secondary inductor (e.g., 332 in FIG. 3) of the center-tapped transformer 330 may be formed on the same layer of one substrate. The primary inductor (e.g., 331 in FIG. 3) and the secondary inductor (e.g., 332 in FIG. 3) of the center-tapped transformer 330 may be formed on different layers, respectively. The center-tapped capacitor 333 included in the center-tapped transformer 330 may be implemented as two equivalent capacitors, as illustrated in FIG. 9. The center-tapped capacitor 333 may be implemented with a plurality of capacitors, and the number of capacitors included in the center-tapped capacitor 333 or their connection relationship is not limited. In FIG. 9, a part 933 may be a part where the first point of the primary inductor (e.g., 331 in FIG. 3) and the center-tapped capacitor 333 are connected. The circuit of FIG. 9 is exemplary, and the actual configuration of the circuit of the phase shifter 246 is not limited.

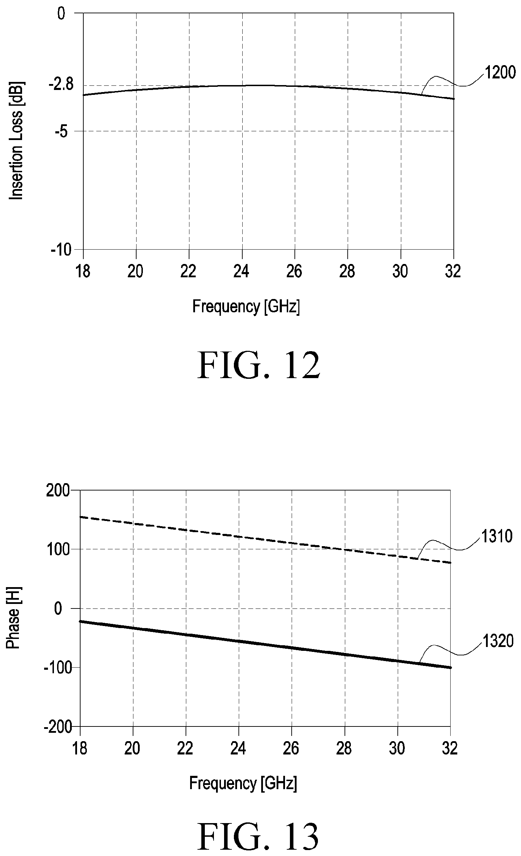

FIG. 10 is a graph illustrating input return loss of a phase shifter according to the embodiment. FIG. 11 is a graph illustrating output return loss of the phase shifter according to an embodiment. FIG. 12 is a graph illustrating insertion loss of a phase shifter according to an embodiment. FIG. 13 is a graph illustrating phases of a signal output from a phase shifter according to an embodiment.

Referring to FIGS. 10, 11, 12, and 13, the design results of a phase shifter based on the single bit of the phase shifter 246 of FIGS. 3, 7, and 8 may be described. For example, the electronic device 100 may adjust a phase using the phase shifter 246.

FIG. 10 is a graph illustrating input return loss 1000 of the phase shifter 246. FIG. 11 is a graph illustrating output return loss 1100 of the phase shifter 246. A frequency band where the input/output return loss of the phase shifter (e.g., the phase shifter 246) is 10dB or less may be referred to as an operating frequency band. Referring to FIGS. 10 and 11, it may be identified that the operating frequency band of the phase shifter 246 of FIGS. 3, 7, and 8 is 22GHz to 32GHz. FIG. 12 is a graph illustrating insertion loss 1200 of the phase shifter 246. Referring to FIG. 12, it may be identified that the insertion loss of the phase shifter 246 is 2.8dB or less in the operating frequency band of 22GHz to 32GHz of the phase shifter 246. FIG. 13 is a graph illustrating phases of a signal output from the phase shifter 246. Referring to the difference between 1310 and 1320 of FIG. 13, a phase change (180 degrees) of a signal output from the phase shifter 246 may be identified. As a result, it may be identified that the phase shifter 246 is a circuit that may adjust a phase by 180 degrees in the operating frequency band of 22GHz to 32GHz.

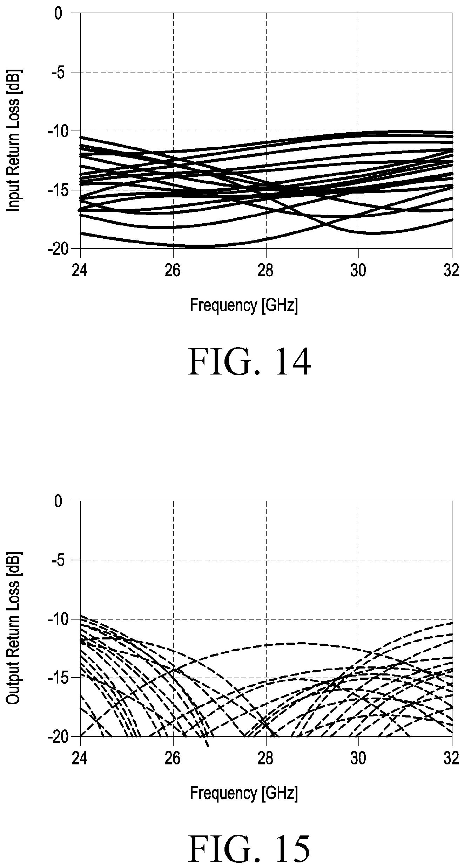

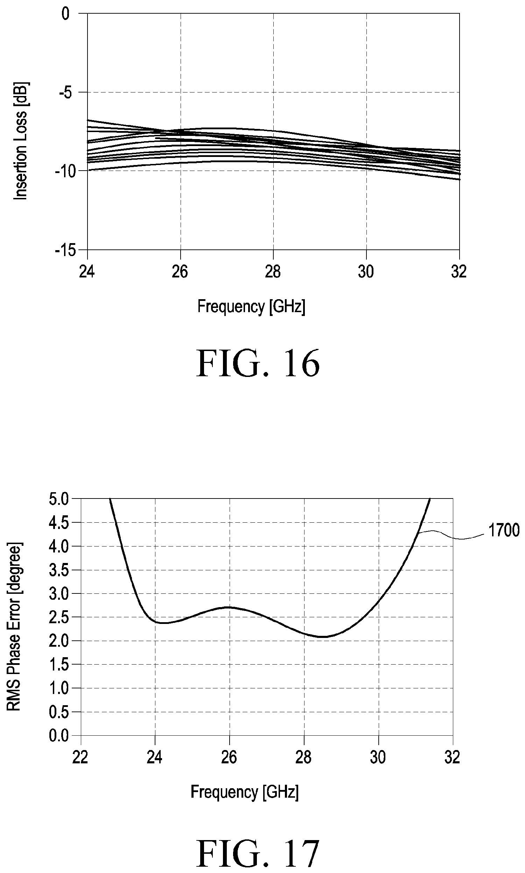

FIG. 14 is a graph illustrating input return loss of a phase shifter according to an embodiment. FIG. 15 is a graph illustrating output return loss of a phase shifter according to an embodiment. FIG. 16 is a graph illustrating insertion return loss of a phase shifter according to an embodiment. FIG. 17 is a root mean square (RMS) average graph of phase errors of a phase shifter according to an embodiment.

With reference to FIGS. 14, 15, 16, and 17, the design results of a 6-bit phase shifter including the phase shifter 246 of FIGS. 3, 7, and 8 may be described. For example, the electronic device 100 may adjust a phase using the 6-bit phase shifter (e.g., the first phase shifter 240 of FIG. 2) including the phase shifter 246. A plurality of result values (a result graph) displayed on each of the graphs of FIGS. 14, 15, and 16 are result values when each sub-phase shifter included in the 6-bit phase shifter including the phase shifter 246 of FIGS. 3, 7, and 8 is adjusted.

FIG. 14 is a graph illustrating input return loss of a 6-bit phase shifter (e.g., the first phase shifter 240 of FIG. 2) including the phase shifter 246. FIG. 15 is a graph illustrating output return loss of a 6-bit phase shifter (e.g., the first phase shifter 240 of FIG. 2) including the phase shifter 246. As described above, a frequency band in which input/output return loss of the 6-bit phase shifter (e.g., the first phase shifter 240 of FIG. 2) including the phase shifter 246 is 10dB or less may be referred to as an operating frequency band. Referring to FIGS. 14 and 15, it may be identified that the operating frequency band of the 6-bit phase shifter (e.g., the first phase shifter 240 of FIG. 2) including the phase shifters 246 of FIGS. 3, 7, and 8 is 24GHz to 30GHz. FIG. 16 is a graph illustrating insertion loss 1200 of the 6-bit phase shifter (e.g., the first phase shifter 240 of FIG. 2) including the phase shifter 246. Referring to FIG. 16, it may be identified that the insertion loss of the 6-bit phase shifter (e.g., the first phase shifter 240 of FIG. 2) including the phase shifter 246 is 6.9dB to 10.3dB in the operating frequency band of 24GHz to 30GHz. FIG. 17 is a graph illustrating the RMS average values of phase errors of the 6-bit phase shifter (e.g., the first phase shifter 240 of FIG. 2) including the phase shifter 246. A phase error may indicate the difference between a target phase shift value and an actual phase shift value of the phase shifter. In FIG. 17, 1700 indicates a graph illustrating RMS average values of phase errors in all cases (e.g., 64 operations) of controlling high and low of each control signal (e.g., a 6-bit control signal) for a 6-bit phase shifter (e.g., the first phase shifter 240 of FIG. 2) including the phase shifter 246. Referring to 1700 of FIG. 17, it may be identified that the phase errors of the 6-bit phase shifter (e.g., the first phase shifter 240 of FIG. 2) including the phase shifter 246 are 2.8 degrees or less in the operating frequency band of 24GHz to 30GHz. As a result, it may be identified that the 6-bit phase shifter (e.g., the first phase shifter 240 of FIG. 2) including the phase shifter 246 operates in the operating frequency band of 24GHz to 30GHz.

Those skilled in the art will understand that the embodiments of the disclosure may be applied in organic conjunction with each other within an applicable range. For example, those skilled in the art will understand that at least some of the operations of an embodiment of the disclosure may be omitted, or at least some of the operations of an embodiment may be applied in organic conjunction with at least some of the operations of another embodiment.

According to an embodiment, the phase shifter 246 may include the center-tapped transformer 330 including the primary inductor 331, the secondary inductor 332 magnetically coupled to the primary inductor 331, and the center-tapped capacitor 333 connected to the primary inductor 331, the first switch 310 electrically connected to the first terminal of the primary inductor 331 and configured to selectively connect the input terminal 391 of the phase shifter 246 and the first terminal of the primary inductor 331, and the second switch 320 electrically connected to the second terminal of the primary inductor 331 and configured to selectively connect the input terminal 391 of the phase shifter 246 and the second terminal of the primary inductor 331. While the first switch 310 is in the on state and the second switch 320 is in the off state, an induced first RF signal having the same phase as a first RF signal input to the input terminal 391 of the phase shifter 246 may be output through the output terminal 392 of the phase shifter 246 connected to the secondary inductor 332. While the first switch 310 is in the off state and the second switch 320 is in the on state, an induced second RF signal having a phase difference of 180 degrees from a second RF signal input to the input terminal 391 of the phase shifter 246 may be output through the output terminal 392 of the phase shifter 246.

According to an embodiment, the center-tapped capacitor 333 may be connected to the first point of the primary inductor 331. The inductance of the first sub-inductor of the primary inductor 331 divided by the first point may be substantially the same as the inductance of the second sub-inductor of the primary inductor 331 divided by the first point.

According to an embodiment, the phase shifter 246 may further include the first matching circuit 710 electrically connected to the first switch 310 and the second switch 320.

According to an embodiment, the first matching circuit 710 may include the first capacitor 830.

According to an embodiment, the phase shifter 246 may further include the second matching circuit 720 electrically connected to the first terminal of the secondary inductor 332.

According to an embodiment, the phase shifter may further include the third inductor 810 electrically connected between the first switch 310 and the first terminal of the primary inductor 331, and the fourth inductor 820 electrically connected between the second switch 320 and the second terminal of the primary inductor 331.

According to an embodiment, the inductance of the third inductor 810 and the inductance of the fourth inductor 820 may be substantially the same.

According to an embodiment, the primary inductor 331 and the secondary inductor 332 may have the same winding direction.

According to an embodiment, the electronic device 100 may include the antennas 248, 258, and 268, the phase shifters 240, 250, and 260 connected to the antennas 248, 258, and 268, the splitter/combiner 270 connected to the phase shifters 240, 250, and 260, the RFIC 220 configured to provide an RF signal to the phase shifters 240, 250, and 260 through the splitter/combiner 270, and the processor 210. Among the phase shifters 240, 250, and 260, a first phase shifter 246 may include the center-tapped transformer 330 including the primary inductor 331, the secondary inductor 332 magnetically coupled to the primary inductor 331, and the center-tapped capacitor 333 connected to the primary inductor 331, the first switch 310 electrically connected to the first terminal of the primary inductor 331 and configured to selectively connect the input terminal 391 of the first phase shifter 246 and the first terminal of the primary inductor 331, and the second switch 320 electrically connected to the second terminal of the primary inductor 331 and configured to selectively connect the input terminal 391 of the phase shifter and the second terminal of the primary inductor 331. The processor 210 may be configured to control on/off of the first switch 310 and the second switch 320. While the first switch 310 is in the on state and the second switch 320 is in the off state, an induced first RF signal having the same phase as a first RF signal input to the input terminal 391 of the first phase shifter 246 may be output through an output terminal 392 of the first phase shifter 246 connected to the secondary inductor 332. While the first switch 310 is in the off state and the second switch 320 is in the on state, an induced second RF signal having a phase difference of 180 degrees from a second RF signal input to the input terminal 391 of the first phase shifter 246 may be output through the output terminal 392 of the first phase shifter 246.

According to an embodiment, the center-tapped capacitor 333 may be connected to the first point of the primary inductor 331, and the inductance of the first sub-inductor of the primary inductor 331 divided by the first point may be substantially the same as the inductance of the second sub-inductor of the primary inductor 331 divided by the first point.

According to an embodiment, the first phase shifter 246 may include the first matching circuit 710 electrically connected to the first switch 310 and the second switch 320.

According to an embodiment, the first matching circuit 710 may include the first capacitor 830.

According to an embodiment, the first phase shifter 246 may include the second matching circuit 720 electrically connected to the first terminal of the secondary inductor 332.

According to an embodiment, the first phase shifter 246 may include the third inductor 810 electrically connected between the first switch 310 and the first terminal of the primary inductor 331, and the fourth inductor 820 electrically connected between the second switch 320 and the second terminal of the primary inductor 331.

According to an embodiment, the inductance of the third inductor 810 and the inductance of the fourth inductor 820 may be substantially the same.

According to an embodiment, the primary inductor 331 and the secondary inductor 332 may have the same winding direction.

The electronic device according to embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B", "at least one of A and B", "at least one of A or B", "A, B, or C", "at least one of A, B, and C", and "at least one of A, B, or C", may include any one of, or all possible combinations of the items enumerated together in a corresponding one of the phrases. As used herein, such terms as "1^{st}" and "2^{nd}", or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with", "coupled to", "connected with", or "connected to" another element (e.g., a second element), it means that the element may be coupled with the other element directly (e.g., wiredly), wirelessly, or via a third element.

As used in connection with embodiments of the disclosure, the term "module" may include a unit implemented in hardware, software, or firmware, and may interchangeably be used with other terms, for example, logic, logic block, part, or circuitry. A module may be a single integral component, or a minimum unit or part thereof, adapted to perform one or more functions. For example, according to an embodiment, the module may be implemented in a form of an application-specific integrated circuit (ASIC).

Embodiments as set forth herein may be implemented as software (e.g., a program) including one or more instructions that are stored in a storage medium (e.g., internal memory or external memory) that is readable by a machine (e.g., the wireless power transmission device 100). For example, a processor (e.g., the processor 201) of the machine (e.g., the wireless power transmission device 100) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to embodiments, each component (e.g., a module or a program) of the above-described components may include a single entity or multiple entities, and some of the multiple entities may be separately disposed in different components. According to embodiments, one or more of the above-described components may be omitted, or one or more other components may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to embodiments, operations performed by the module, the program, or another component may be carried out sequentially, in parallel, repeatedly, or heuristically, or one or more of the operations may be executed in a different order or omitted, or one or more other operations may be added.

## Claims

1. A phase shifter (246) comprising:
a center-tapped transformer (330) including a primary inductor (331), a secondary inductor (332) magnetically coupled to the primary inductor (331), and a center-tapped capacitor (333) connected to the primary inductor (331);
a first switch (310) electrically connected to a first terminal of the primary inductor (331) and configured to selectively connect an input terminal (391) of the phase shifter (246) and the first terminal of the primary inductor (331); and
a second switch (320) electrically connected to a second terminal of the primary inductor (331) and configured to selectively connect the input terminal (391) of the phase shifter (246) and the second terminal of the primary inductor (331),
wherein while the first switch (310) is in an on state and the second switch (320) is in an off state, an induced first RF signal having the same phase as a first RF signal input to the input terminal (391) of the phase shifter (246) is output through an output terminal (392) of the phase shifter (246) connected to the secondary inductor (332), and
wherein while the first switch (310) is in an off state and the second switch (320) is in an on state, an induced second RF signal having a phase difference of 180 degrees from a second RF signal input to the input terminal (391) of the phase shifter (246) is output through the output terminal (392) of the phase shifter (246).

2. The phase shifter (246) of claim 1, wherein the center-tapped capacitor (333) is connected to a first point of the primary inductor (331), and inductance of a first sub-inductor of the primary inductor (331) divided by the first point is substantially the same as inductance of a second sub-inductor of the primary inductor (331) divided by the first point.

3. The phase shifter (246) of claim 1 or 2, further comprising a first matching circuit (710) electrically connected to the first switch (310) and the second switch (320).

4. The phase shifter (246) of at least one of claims 1 to 3, wherein the first matching circuit (710) includes a first capacitor (830).

5. The phase shifter (246) of at least one of claims 1 to 4, further comprising a second matching circuit (720) electrically connected to a first terminal of the secondary inductor (332).

6. The phase shifter (246) of at least one of claims 1 to 5, further comprising:
a third inductor (810) electrically connected between the first switch (310) and the first terminal of the primary inductor (331); and
a fourth inductor (820) electrically connected between the second switch (320) and the second terminal of the primary inductor (331).

7. The phase shifter (246) of at least one of claims 1 to 6, wherein inductance of the third inductor (810) and inductance of the fourth inductor (820) are substantially the same.

8. The phase shifter (246) of at least one of claims 1 to 7, wherein the primary inductor (331) and the secondary inductor (332) have the same winding direction.

9. An electronic device (100) comprising:
antennas (248, 258, 268);
phase shifters (240, 250, 260) connected to the antennas (248, 258, 268);
a splitter/combiner (270) connected to the phase shifters (240, 250, 260);
an RFIC (220) configured to provide an RF signal to the phase shifters (240, 250, 260) through the splitter/combiner (270); and
a processor (210),
wherein among the phase shifters (240, 250, 260), a first phase shifter (246) includes:
a center-tapped transformer (330) including a primary inductor (331), a secondary inductor (332) magnetically coupled to the primary inductor (331), and a center-tapped capacitor (333) connected to the primary inductor (331);
a first switch (310) electrically connected to a first terminal of the primary inductor (331) and configured to selectively connect an input terminal (391) of the first phase shifter (246) and the first terminal of the primary inductor (331); and
a second switch (320) electrically connected to a second terminal of the primary inductor (331) and configured to selectively connect the input terminal (391) of the phase shifter and the second terminal of the primary inductor (331),
wherein the processor (210) is configured to control on/off of the first switch (310) and the second switch (320),
wherein while the first switch (310) is in an on state and the second switch (320) is in an off state, an induced first RF signal having the same phase as a first RF signal input to the input terminal (391) of the first phase shifter (246) is output through an output terminal (392) of the first phase shifter (246) connected to the secondary inductor (332), and
wherein while the first switch (310) is in an off state and the second switch (320) is in an on state, an induced second RF signal having a phase difference of 180 degrees from a second RF signal input to the input terminal (391) of the first phase shifter (246) is output through the output terminal (392) of the first phase shifter (246).

10. The electronic device (100) of claim 9, wherein the center-tapped capacitor (333) is connected to a first point of the primary inductor (331), and inductance of a first sub-inductor of the primary inductor (331) divided by the first point is substantially the same as inductance of a second sub-inductor of the primary inductor (331) divided by the first point.

11. The electronic device (100) of claim 9 or 10, wherein the first phase shifter (246) further includes a first matching circuit (710) electrically connected to the first switch (310) and the second switch (320).

12. The electronic device (100) of at least one of claims 9 to 11, wherein the first matching circuit (710) includes a first capacitor (830).

13. The electronic device (100) of at least one of claims 9 to 12, wherein the first phase shifter (246) further includes a second matching circuit (720) electrically connected to a first terminal of the secondary inductor (332).

14. The electronic device (100) of at least one of claims 9 to 13, wherein the first phase shifter (246) further includes:
a third inductor (810) electrically connected between the first switch (310) and the first terminal of the primary inductor (331); and
a fourth inductor (820) electrically connected between the second switch (320) and the second terminal of the primary inductor (331).

15. The electronic device (100) of at least one of claims 9 to 14, wherein inductance of the third inductor (810) and inductance of the fourth inductor (820) are substantially the same.
